# EUROPEAN PATENT APPLICATION

(11) **EP 2 555 267 A1**
(43) Date of publication of application: **06.02.2013**
(21) Application number: 11180547.9
(22) Date of filing: 08.09.2011
(51) Int. Cl.: H01L 41/00, G08B 3/10

(54) **Transducer module**

(30) Priority: 04.08.2011 TW 100127826
(71) Applicant: Chief Land Electronic Co. Ltd., Wugu Dist., New Taipei City 248 (TW)
(72) Inventor: Chuang, Tsi-Yu, 52142 Changhua County (TW); Ching, Chia-Nan, 32097 Zhongli City Taoyuan County (TW); Liu, Bao-Zheng, 31053 Hsinchu County (TW)
(74) Representative: Karakatsanis, Georgios

(57) **Abstract**

The present invention is directed to a transducer module including a first transducer and a second transducer. The second transducer is disposed between the first transducer and a first plate.

## Description

### BACKGROUND OF THE INVENTION

### 1. FIELD OF THE INVENTION

The present invention generally relates to a transducer, and more particularly to a transducer module utilizing a transducer for generating acoustic effect and haptic feedback.

### 2. DESCRIPTION OF RELATED ART

A transducer is a device that converts one type of energy to another. A motor and an electric generator are common electromechanical transducers. The motor converts electric energy to mechanical energy via electromagnetic induction. One type of motor, such as a brush DC motor, a servo motor or a step motor, outputs the mechanical energy in rotational movement; another type of motor, such as a linear motor, converts electric energy directly to linear movement. The electric generator, on the other hand, converts mechanical energy to electric energy. A single-phase generator or a three-phase generator is commonly used in an electric power system. Moreover, the transducer may be implemented by smart material, such as piezoelectric material, electro-active polymer (EAP), shape memory alloy (SMA), magnetostrictive material or electrostrictive material.

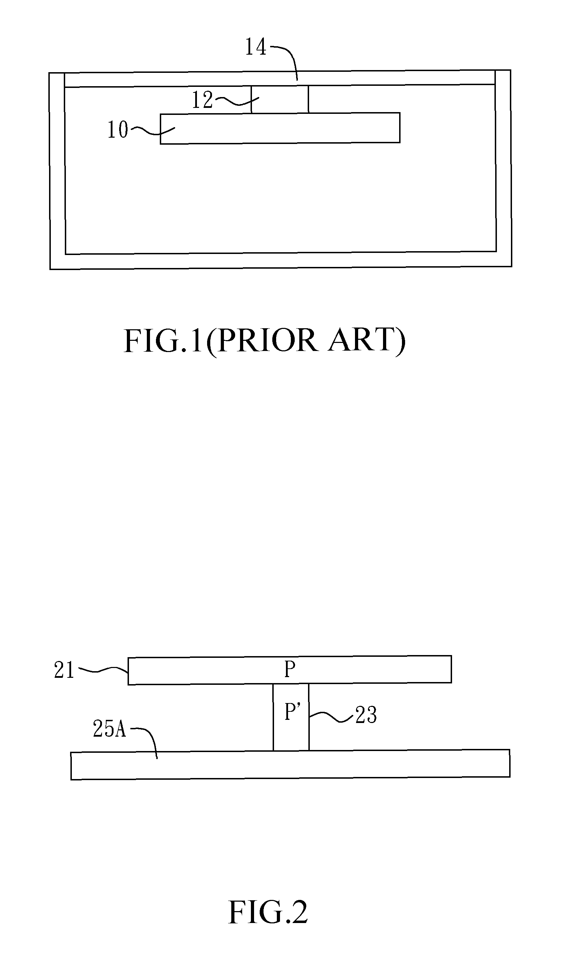

FIG. 1 shows a conventional transducer device, in which a transducer 10, such as a unimorph actuator, bimorph actuator or multimorph actuator, is made of piezoelectric material, which converts electric signals to mechanical movement via converse piezoelectric effect. A common piezoelectric plate has a rectangular shape, a round shape (as of a buzzer) or other shape, which is dependent on actual applications. Considering output strength as a performance index, the multimorph actuator is better than the bimorph actuator, which is further better than the unimorph actuator. Considering cost, as the price of the piezoelectric plate is proportional to its stacked number, the unimorph actuator takes priority if the performance is not strictly required.

The structure shown in FIG. 1 is a conventional vibration propagation device, in which the vibration energy of the transducer 10 may be transferred to a top housing 14 via a sticking element 12, thereby generating acoustic effect or haptic feedback. The transducer is ordinarily fixed, by sticking or locking, under the top housing 14 such that the vibration energy may be directly transferred to the top housing 14. However, the commonly used material of the transducer 10 limits the swing amplitude and output strength at endpoints or edges of the transducer 10, such that the transferred vibration energy is restrained, the haptic reaction of the haptic feedback is not evident or the sound pressure level (SPL) generated on the top housing 14 is low.

For the foregoing reasons, a need has arisen to propose a novel transducer module for simplifying assembly procedure or increasing inertial force.

### SUMMARY OF THE INVENTION

In view of the foregoing, it is an object of the embodiment of the present invention to provide a transducer module, which improves acoustic propagation, haptic feedback or the assembly procedure. The embodiment of the present invention may increase swing amplitude or enhance the transferred inertial force.

According to one embodiment of the present invention, the transducer module includes a first transducer and a second transducer. Specifically, the second transducer is disposed between a first plate and the first transducer.

According to another embodiment of the present invention, the transducer module further includes a block member disposed between the first transducer and a second plate. According to a further embodiment of the present invention, the transducer module further includes a third transducer disposed between the first transducer and the second plate.

### BRIEF DESCRIPTION OF THE DRAWINGS

FIG. 1 shows a conventional transducer device;
FIG. 2 shows a cross section of a transducer module according to one embodiment of the present invention;
FIG. 3A to FIG. 3D show cross sections of some transducer modules according to embodiments of the present invention;
FIG. 4A shows a detailed cross section of a first/second/third transducer;
FIG. 4B shows a detailed cross section of another first/second/third transducer; and
FIG. 5A to FIG. 5E show top views of some first transducers of a variety of shapes.

### DETAILED DESCRIPTION OF THE INVENTION

FIG. 2 shows a cross section of a transducer module according to one embodiment of the present invention. In the embodiment, the transducer module is used, but not limited, to convert electric energy to mechanical energy. The transducer module of the embodiment includes a first transducer (denoted as P) 21 and a second transducer (denoted as P') 23. Specifically, the second transducer 23 is disposed between a first plate 25A and the first transducer 21. The first transducer 21 may be insulated from the second transducer 23 by an insulator (not shown in the figure). When the first transducer 21 is driven with a time-varying electric field, the first transducer 21, according to its electromechanical coupling characteristic, converts the time-varying electric field into mechanical energy and then generates vibration at its ends. The first transducer 21 has a mechanical connection with the first plate 25A via the second transducer 23. When the ends of the first transducer 21 moves upward and downward, the generated inertial force is transferred to the first plate 25A via the second transducer 23. If the first plate 25A is a touch sensitive plate, the inertial vibration then generates haptic feedback on the first plate 25A, thereby increasing input preciseness of a touch sensitive interface or virtual reality of an interactive application program.

Further, as sound, on it merit, is commonly transferred via a propagation medium (e.g., air, water or metal), the inertial force generated from the first transducer 21 strikes the first plate 25A to generate acoustic effect and, therefore, the first plate 25A may be used as the propagation medium to act as a flat panel loudspeaker. Moreover, the second transducer 23 may also be driven by a time-varying electric field when the first transducer 21 is driven, such that the vibration of the first transducer 21 is in phase (i.e., constructive interference) or nearly in phase (with little phase difference) with the vibration of the second transducer 23, thereby increasing the amplitude of vibration on the first plate 25A and enhancing haptic feedback or acoustic effect.

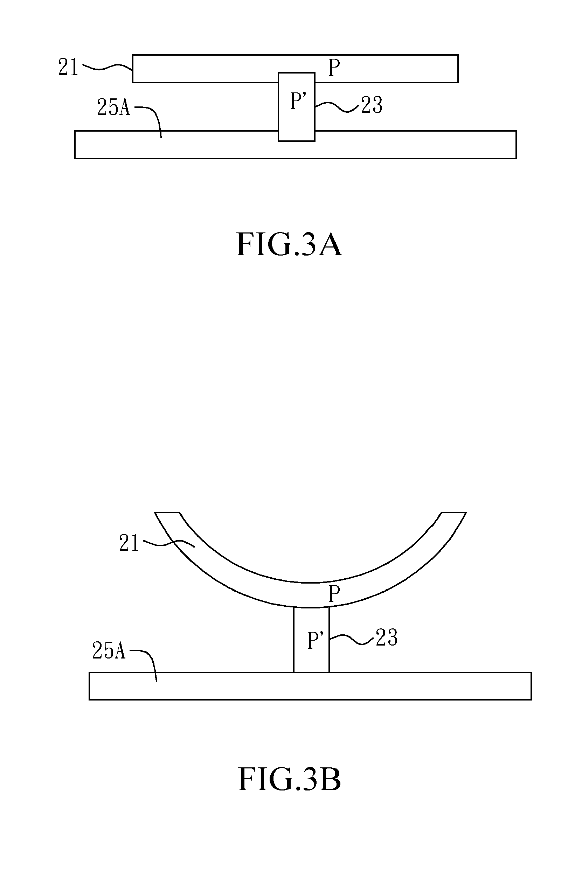

As shown in FIG. 3A, the second transducer 23 may be disposed on the surface of the first plate 25A with an embedded (or inserted) scheme, and the second transducer 23 may be disposed on the surface of the first transducer 21 with the embedded scheme. The first transducer 21 of FIG. 3A has a planar shape. However, other shapes may be used instead. For example, FIG. 3B shows a cross section of another transducer module, in which the first transducer 21 has a curved shape. The transducer module of FIG. 3A operates in a manner similar to the transducer module of FIG. 2 with the exception that the second transducers 23 are disposed in different manners. The transducer module of FIG. 3B operates in a manner similar to the transducer module of FIG. 2 with the exception that the second transducers 23 have different geometric shapes.

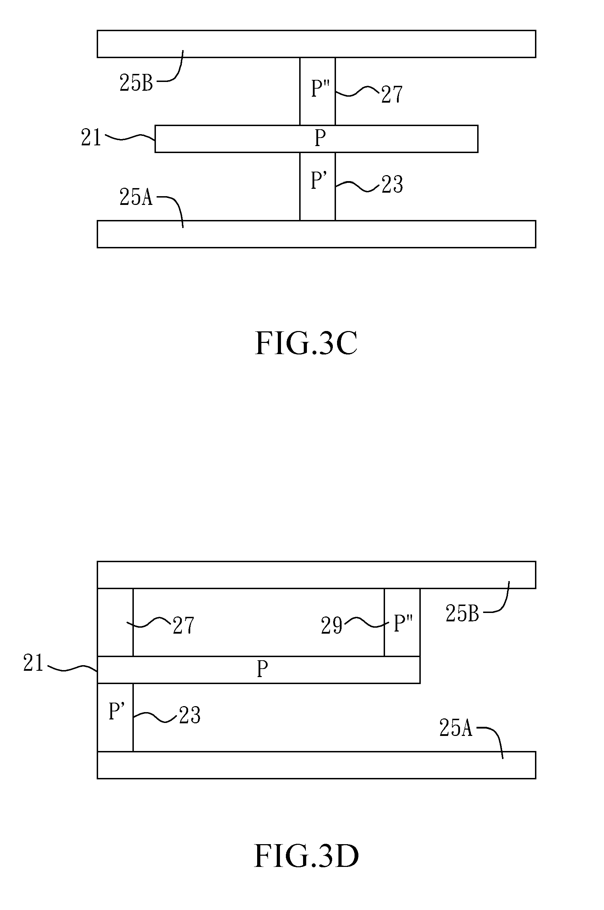

FIG. 3C shows a cross section of a further transducer module, which further includes a block member 27 and a second plate 25B. Specifically, the block member 27 is disposed between the first transducer 21 and the second plate 25B. If the first plate 25A is used as a fixed base, the ends of the first transducer 21 move upward and downward when the first transducer 21 is driven with a time-varying electric field, and the inertial force from the up-and-down vibration is transferred to the second plate 25B via the block member 27. If the second plate 25B is a touch pad, a touch sensitive plate or other touch sensitive interface, the vibration may generate haptic feedback. Further, the second plate 25B may be used as a vibration plat panel to act as a flat panel loudspeaker, thereby generating acoustic effect. Moreover, the second transducer 23 may also be driven by a time-varying electric field when the first transducer 21 is driven, such that the vibration of the first transducer 21 is in phase (i.e., constructive interference) or nearly in phase (with little phase difference) with the vibration of the second transducer 23, thereby increasing the amplitude of vibration on the second plate 25B and enhancing haptic feedback or acoustic effect. The block member 27 mentioned above may be replaced with a third transducer (denoted as P"). When the vibrations of the first transducer 21, the second transducer 23 and the third transducer P" are in phase or nearly in phase, the amplitude of vibration on the second plate 25B and haptic feedback or acoustic effect may then be enhanced.

FIG. 3D shows a cross section of a further transducer module, which further includes a third transducer (denoted as P") 29 disposed between the first transducer 21 and the second plate 25B. The first transducer 21 may be insulated from the third transducer 29 by an insulator (not shown in the figure). In the embodiment, both the block member 27 and the second transducer 23 are disposed near one end of the first transducer 21, and the third transducer 29 is disposed near another end of the first transducer 21. The transducer module of FIG. 3D operates in a manner similar to the transducer module of FIG. 3C, with the exception that the second transducer 23 and the block member 27 of FIG. 3D are disposed near one end of the first transducer 21, and the third transducer 29 is further disposed at another end of the first transducer 21. When the inertial forces generated from the first transducer 21, the second transducer 23 and the third transducer 29 are in phase or nearly in phase, and then exert on the second plate 25B via the block member 27 and the third transducer 29, the amplitude of vibration on the second plate 25B and haptic feedback or acoustic effect may then be enhanced. The composing elements of the transducer module of FIG. 2 and FIGs. 3A-3D will be described below.

In the embodiment, the combination of some or all composing elements may be manufactured in a module in order to speed up the assembly. That is, some or all of the first transducer 21, the second transducer 23, the first plate 25A, the block member 27, the second plate 25B and the third transducer 29 may be manufactured in a module. The interconnection among the composing elements may be realized by integrally forming, sticking, locking, screwing or other technique. The first plate 25A or the second plate 25B may be a screen, a touch sensitive plate, a frame, a substrate or a housing. The block member 27 may be hollow or solid, may have a tube, cylindrical or other shapes, and the quantity may be one or greater than one.

In the embodiment, the first transducer 21, the second transducer 23 or the third transducer 29 may be made of smart material such as, but not limited to, piezoelectric material (e.g., lead-zirconate-titanate (PZT)), electro-active polymer (EAP), shape memory alloy (SMA), magnetostrictive material, a voice coil motor, an eccentric rotating mass (ERM) motor or a linear resonant actuator (LRA).

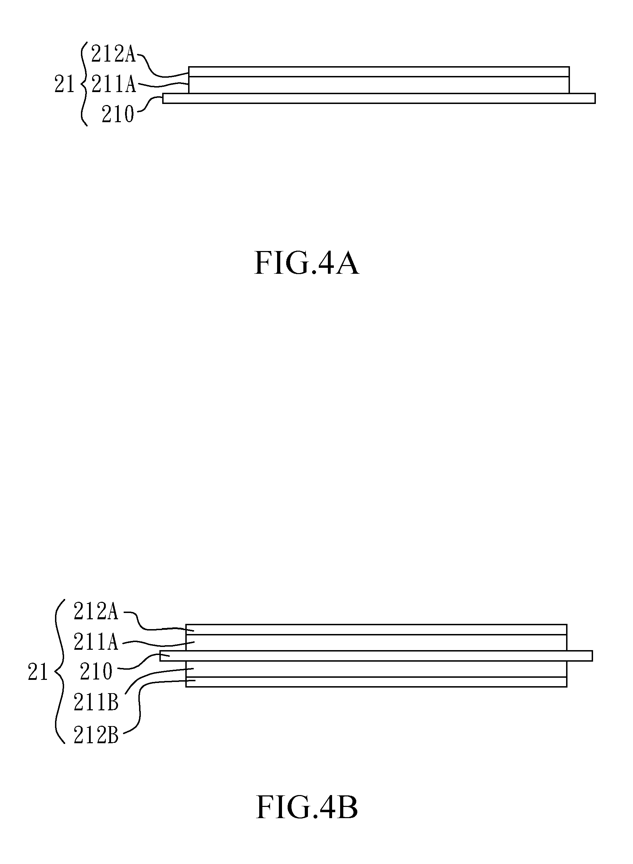

FIG. 4A shows a detailed cross section of a first transducer 21, the second transducer 23 or the third transducer 29. The first transducer 21 will be exemplified below. The first transducer 21 includes a conductive layer 210, a first smart material layer 211A and a first electrode layer 212A. Specifically, the first smart material layer 211A is formed on a top surface of the conductive layer 210, and the first electrode layer 212A is then coated on a top surface of the first smart material layer 211A. The conductive layer 210 and the first electrode layer 212A are used as two electrodes for driving the first smart material layer 211A, and the conductive layer 210, in practice, is made of thin material layer (e.g., an electrode layer) or plate-type material layer (e.g., a metal plate). A conductive layer 210 made of a metal plate can increase toughness and durability of the first transducer 21, and can increase the inertial force for generating acoustic effect or haptic feedback. If single layer of the first smart material layer 211A made of piezoelectric material is used, the first transducer 21 of FIG. 4A may be called a unimorph actuator. The first transducer 21 may, in practice, use two or more layers of the first smart material layer 211A, therefore resulting in a multi-layer actuator.

FIG. 4B shows a detailed cross section of another first transducer 21, the second transducer 23 or the third transducer 29. The first transducer 21 will be exemplified below. The first transducer 21 includes a conductive layer 210, a first smart material layer 211A, a first electrode layer 212A, a second smart material layer 211B and a second electrode layer 212B. Specifically, the first smart material layer 211A is formed on a top surface of the conductive layer 210, and the first electrode layer 212A is then coated on a top surface of the first smart material layer 211A. The second smart material layer 211B is formed on a bottom surface of the conductive layer 210, and the second electrode layer 212B is then coated on a bottom surface of the second smart material layer 211B. The conductive layer 210 is used as a common electrode for the first/second smart material layers 211A/B, and the first/second electrode layers 212A/B are used as two electrodes for driving the first/second smart material layers 211A/B. As two layers (i.e., the first and second smart material layers 211A/B) made of piezoelectric material are used, the first transducer 21 of FIG. 4B may be called a bimorph actuator. The first transducer 21 may, in practice, use two or more layers of the first/second smart material layer 211A/B on at least one side of the first transducer 21, therefore resulting in a multi-layer actuator.

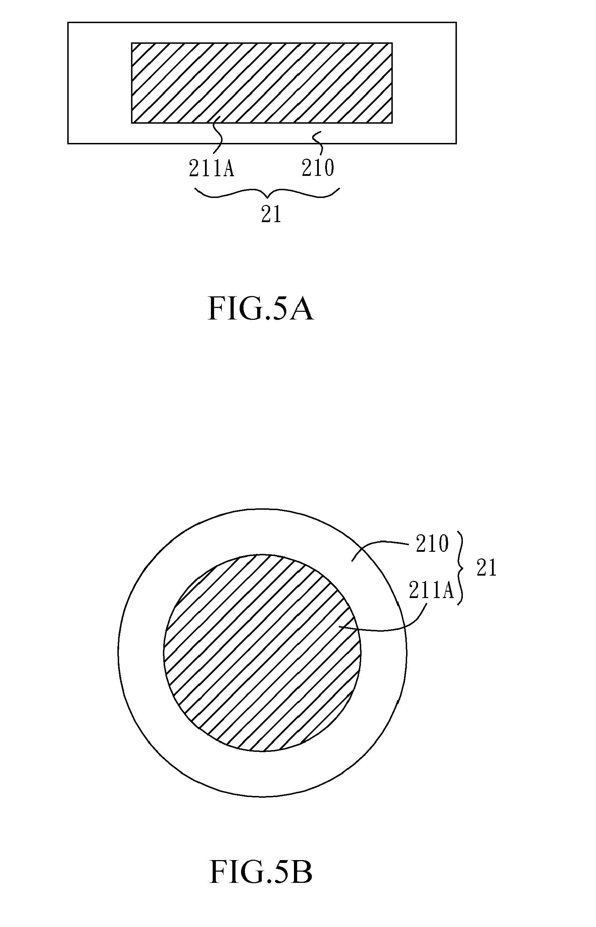

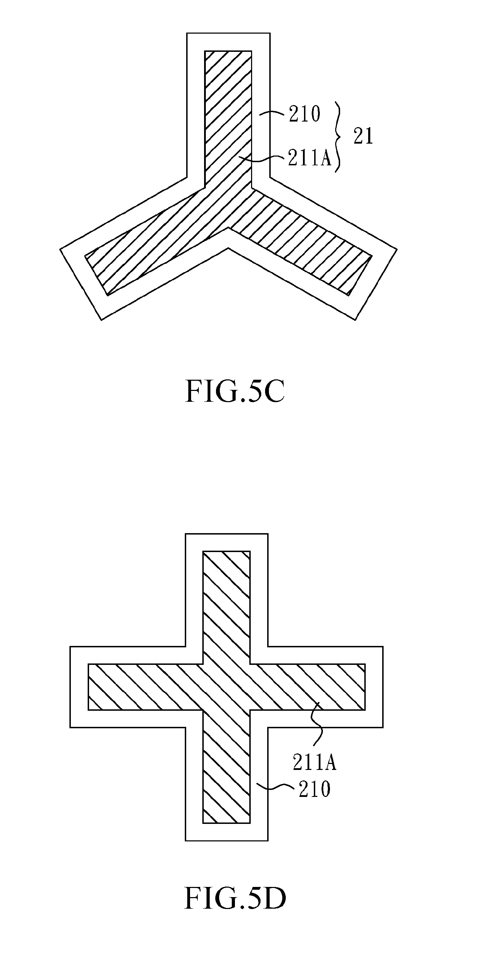

FIG. 5A to FIG. 5E show top views of some first transducers 21 of a variety of shapes. Specifically, FIG. 5A shows a top view of a rectangular-shape first transducer 21, which includes a rectangular-shape conductive layer 210 and a rectangular-shape first smart material layer 211A (with the first electrode layer 212A being omitted for brevity). FIG. 5B shows a top view of a circular-shape first transducer 21, which includes a circular-shape conductive layer 210 and a circular-shape first smart material layer 211A (with the first electrode layer 212A being omitted for brevity). FIG. 5C shows a top view of a tri-fork star-shape first transducer 21, which includes a tri-fork star-shape conductive layer 210 and a tri-fork star-shape first smart material layer 211A (with the first electrode layer 212A being omitted for brevity). FIG. 5D shows a top view of a cross-shape first transducer 21, which includes a cross-shape conductive layer 210 and a cross-shape first smart material layer 211A (with the first electrode layer 212A being omitted for brevity).

The first transducer 21 shown above is exemplified as a unimorph actuator. In practice, a second smart material layer 211B may be added on a bottom surface of the conductive layer 210, and a second electrode layer 212B may be coated on a bottom surface of the second smart material layer 211B, thereby resulting in the bimorph actuator as discussed above.

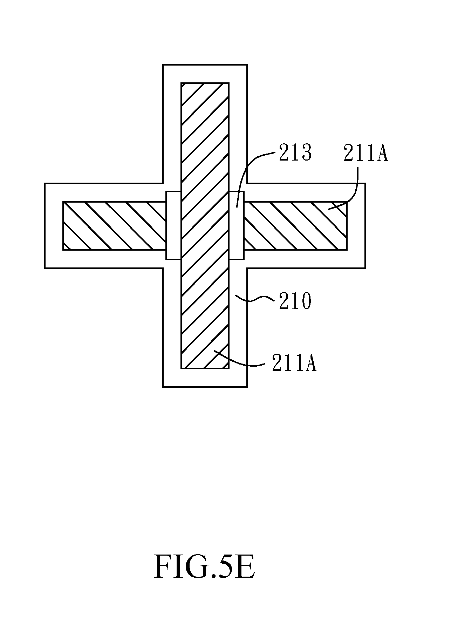

FIG. 5E shows a top view of another cross-shape first transducer 21, which includes two first smart material layers 211A disposed in cruciform on a top surface of a cross-shape conductive layer 210, wherein the two first smart material layers 211A are insulated from each other by an insulator 213, which may be an insulating layer or an insulating member.

Although specific embodiments have been illustrated and described, it will be appreciated by those skilled in the art that various modifications may be made without departing from the scope of the present invention, which is intended to be limited solely by the appended claims.

## Claims

1. A transducer module, comprising:
a first transducer; and
a second transducer disposed between a first plate and the first transducer.

2. The transducer module of claim 1, wherein the second transducer is disposed on the first plate with an embedded scheme.

3. The transducer module of claim 1, wherein the second transducer is disposed on the first transducer with an embedded scheme.

4. The transducer module of claim 1, wherein the first transducer has a planar shape.

5. The transducer module of claim 1, wherein the first transducer has a curved shape.

6. The transducer module of claim 1, further comprising a block member disposed between the first transducer and a second plate.

7. The transducer module of claim 6, further comprising a third transducer disposed between the first transducer and the second plate.

8. The transducer module of claim 6, wherein the first plate or the second plate is a screen, a touch sensitive plate, a frame, a substrate or a housing.

9. The transducer module of claim 7, wherein the first transducer, the second transducer or the third transducer is made of piezoelectric material, electro-active polymer (EAP) or shape memory alloy (SMA), magnetostrictive material, a voice coil motor, an eccentric rotating mass (ERM) motor or a linear resonant actuator (LRA).

10. The transducer module of claim 9, wherein the piezoelectric material is lead-zirconate-titanate (PZT).

11. The transducer module of claim 7, wherein the first transducer, the second transducer or the third transducer comprises:
a conductive layer;
at least one first smart material layer, formed on a top surface of the conductive layer; and
at least one first electrode layer, formed on a top surface of the first smart material layer.

12. The transducer module of claim 11, wherein the conductive layer is a metal plate.

13. The transducer module of claim 1, wherein the first transducer has a rectangular, circular, cross or tri-fork star shape.

14. The transducer module of claim 13, wherein the cross-shape first transducer comprises a cross-shape conductive layer and two first smart material layers that are disposed in cruciform on a top surface of the cross-shape conductive layer, wherein the two first smart material layers are insulated from each other by an insulator.

15. The transducer module of claim 11, wherein the first transducer, the second transducer or the third transducer further comprises:
at least one second smart material layer, formed on a bottom surface of the conductive layer; and
at least one second electrode layer, formed on a bottom surface of the second smart material layer.
